**Europäisches Patentamt**

**European Patent Office**

**Office européen des brevets**

(19)

(11) Veröffentlichungsnummer: **0 226 082**
**B1**

(12) **EUROPÄISCHE PATENTSCHRIFT**

(45) Veröffentlichungstag der Patentschrift:
02.05.90

(51) Int. Cl.⁴: **G01R 27/26**, G12B 17/02

(21) Anmeldenummer: **86116316.0**

(22) Anmeldetag: **25.11.86**

(54) **Kapazitätsmessschaltung.**

(30) Priorität: **13.12.85 DE 3544187**

(43) Veröffentlichungstag der Anmeldung:
**24.06.87 Patentblatt 87/26**

(45) Bekanntmachung des Hinweises auf die Patenterteilung:
**02.05.90 Patentblatt 90/18**

(84) Benannte Vertragsstaaten:
**CH DE FR GB IT LI NL**

(56) Entgegenhaltungen:
**DE-A- 1 673 841**
**DE-A- 3 143 114**
**DE-B- 2 744 785**
**US-A- 3 706 980**
**US-A- 3 781 672**

(73) Patentinhaber: **FLOWTEC AG, Kägenstrasse 4,
CH-4153 Reinach BL 1(CH)**

(72) Erfinder: **Herzog, Michael, Sommergasse 8,
CH-4108 Witterswil(CH)**

(74) Vertreter: **Leiser, Gottfried, Dipl.-Ing. et al,
Patentanwälte Prinz, Leiser, Bunke & Partner
Manzingerweg 7, D-8000 München 60(DE)**

## Beschreibung

Die Erfindung betrifft eine Kapazitätsmeßschaltung mit einer Umschaltanordnung, welche die Meßkapazität mit einer vorgegebenen Umschaltfrequenz periodisch abwechselnd zur Aufladung an eine konstante Spannung legt und zur Entladung mit einem Speicherkondensator verbindet, dessen Kapazität groß gegen die Meßkapazität ist und dessen Klemmenspannung durch einen kontrollierten Entladestrom im wesentlichen auf einem konstanten Bezugspotential gehalten wird, wobei die Größe des Entladestroms der Meßkapazität proportional ist und den Meßwert darstellt.

Kapazitätsmeßschaltungen dieser Art, die aus der DE-OS 31 43 114 bekannt sind, arbeiten nach dem Prinzip der "geschalteten Kondensatoren" ("switched capacitors"). Die Kapazitätsmessung beruht auf der Messung des mittleren Entladestroms der periodisch abwechselnd auf eine konstante Spannung aufgeladenen und entladenen Meßkapazität. Gewöhnlich wird der mittlere Entladestrom durch einen Strom-Spannungs-Wandler in eine Spannung umgesetzt, die der Meßkapazität proportional ist. Durch Verwendung von zwei nach dem gleichen Prinzip arbeitenden Schaltungszweigen ist es insbesondere möglich, Kapazitätsdifferenzen zwischen zwei Meßkapazitäten mit großer Empfindlichkeit und Genauigkeit zu messen, selbst wenn die Kapazitätsdifferenzen sehr klein gegen die Meßkapazitäten sind.

Andererseits ist bei Kapazitätsmeßschaltungen oder kapazitiven Sensoren, beispielsweise aus der US-PS 3 781 672 und der DE-AS 27 44 785, das Prinzip der "aktiven Schirmung" bekannt, das darin besteht, daß das Potential einer der Meßkapazität oder der Sensorkapazität zugeordneten Abschirmung ständig dem Potential der abzuschirmenden Elektrode nachgeführt wird. Dadurch ist es möglich, den Einfluß von Streukapazitäten und Störfeldern auf die Meß- oder Sensorkapazität auszuschalten. Die Abschirmung kann beispielsweise eine die Meß- oder Sensorelektrode umgebende Abschirmelektrode sein, oder auch die Abschirmung eines Kabels, das die Meß- oder Sensorkapazität mit der Kapazitätsmeßschaltung verbindet. Nach dem Stand der Technik erfolgt die aktive Schirmung dadurch, daß das Potential der abgeschirmten Elektrode abgetastet und über einen Impedanzwandler an die Abschirmung angelegt wird. Diese Lösung ist aufwendig, weil als Impedanzwandler ein Operationsverstärker benötigt wird, der hohen Anforderungen an Geschwindigkeit und Eingangskapazität genügen muß.

Der Erfindung liegt die Aufgabe zugrunde, bei einer Kapazitätsmeßschaltung der eingangs angegebenen Art eine aktive Schirmung auf sehr einfache und wirksame Weise zu erzielen.

Zur Lösung dieser Aufgabe enthält die Kapazitätsmeßschaltung nach der Erfindung eine weitere Umschaltanordnung, welche eine der Meßkapazität zugeordnete Abschirmung mit der Umschaltfrequenz periodisch abwechselnd an Potentiale legt, die im wesentlichen der konstanten Spannung bzw. dem Bezugspotential entsprechen.

Bei der Kapazitätsmeßschaltung nach der Erfindung wird die Tatsache ausgenutzt, daß das Potential der abzuschirmenden Elektrode nur zwei abwechselnde Werte annimmt, nämlich entweder das Bezugspotential oder das Potential der konstanten Spannung, auf die die Meßkapazität aufgeladen wird. Daher wird auf eine Abtastung und Rückführung des abzuschirmenden Potentials verzichtet; statt dessen werden einfach im Takt der Umschaltfrequenz abwechselnd die beiden Potentialwerte an die Abschirmung angelegt. Hierfür genügt eine weitere Umschaltanordnung einfacher Art. Als besonderer Vorteil erweist es sich, daß keine engen Zeittoleranzen für die Ansteuerung und Ansprechgeschwindigkeit der weiteren Umschaltanordnung bestehen, denn infolge des Prinzips der geschalteten Kondensatoren führen selbst erhebliche Zeitverschiebungen zwischen den Potentialänderungen der abgeschirmten Elektrode einerseits und der Abschirmung andererseits nicht zu Meßfehlern, wenn gewisse leicht zu erfüllende Bedingungen eingehalten werden.

Weitere Merkmale und Vorteile der Erfindung ergeben sich aus der folgenden Beschreibung von Ausführungsbeispielen, die in der Zeichnung dargestellt sind. In der Zeichnung zeigt:

Fig. 1 das Prinzipschaltbild einer Ausführungsform der Kapazitätsmeßschaltung nach der Erfindung,

Fig. 2 Zeitdiagramme zur Erläuterung der Funktionsweise der Kapazitätmeßschaltung von Fig. 1,

Fig. 3 das Prinzipschaltbild einer anderen Ausführungsform der Kapazitätsmeßschaltung nach der Erfindung und

Fig. 4 Zeitdiagramme zur Erläuterung der Funktionsweise der Kapazitätsmeßschaltung von Fig. 3.

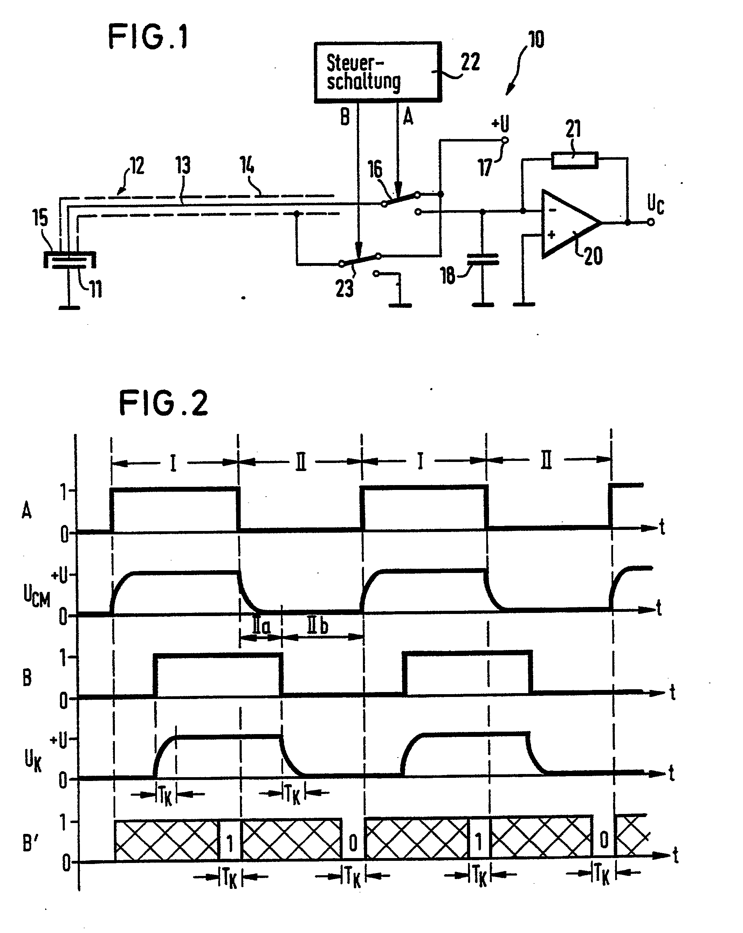

Die in Fig. 1 gezeigte Kapazitätsmeßschaltung 10 liefert nach dem aus der DE-OS 31 43 114 bekannten Prinzip der "geschalteten Kondensatoren" ("switched capacitors") ein Ausgangssignal, das der Kapazität $C_M$ eines Meßkondensators 11 proportional ist. Der Meßkondensator 11 kann sich in größerer Entfernung von der Kapazitätsmeßschaltung 10 befinden und ist mit dieser über ein abgeschirmtes Kabel 12 verbunden, das einen abgeschirmten Innenleiter 13 und eine Kabelabschirmung 14 hat. Wenn am Ort des Meßkondensators 11 eine Abschirmelektrode 15 vorhanden ist, ist diese mit der Kabelabschirmung 14 verbunden.

Die Kapazitätsmeßschaltung 10 enthält einen Umschalter 16, der in der einen Stellung, die in Fig. 1 gezeigt ist, den Meßkondensator 11 über den Innenleiter 13 des Kabels 12 mit einer Klemme 17 verbindet, die gegen Masse eine konstante positive Gleichspannung +U führt, die beispielsweise die Betriebsspannung der Schaltung ist. In der anderen Stellung verbindet der Umschalter 16 den Meßkondensator 11 mit einem Speicherkondensator 18, dessen Kapazität $C_0$ sehr groß gegen die Meßkapazität $C_M$ ist. An die miteinander verbundenen Klemmen des Umschalters 16 und des Speicherkondensators 18 ist auch der invertierende Eingang eines Operationsverstärkers 20 angeschlossen, dessen nichtinvertierender Eingang an Masse liegt und dessen Rückkopplungskreis zwischen dem Ausgang und dem invertierenden Eingang einen Widerstand 21 enthält.

Der Umschalter 16 wird durch ein Steuersignal A betätigt, das an einem Ausgang einer Steuerschaltung 22 abgegeben wird. Die Steuerschaltung 22 gibt an einem zweiten Ausgang ein Steuersignal B ab, das einen Umschalter 23 betätigt, der die Kabelabschirmung 14 des Kabels 12 in der einen Stellung an die Spannung +U der Klemme 17 und in der anderen Stellung an Masse legt.

Die Funktionsweise der Kapazitätsmeßschaltung von Fig. 1 soll anhand der Zeitdiagramme von Fig. 2 erläutert werden.

Das Diagramm A von Fig. 2 zeigt den zeitlichen Verlauf des Steuersignals A, das den Umschalter 16 betätigt. Das Steuersignal A nimmt periodisch abwechselnd zwei Zustände 0 oder 1 an, wobei angenommen wird, daß der Umschalter 16 beim Wert 1 des Steuersignals A die in Fig. 1 gezeigte Stellung hat, in der er den Meßkondensator 11 mit der Klemme 17 verbindet, während er beim Wert 0 des Steuersignals A den Meßkondensator 11 von der Klemme 17 abtrennt und dafür mit dem Speicherkondensator 18 verbindet.

Das Diagramm $U_{CM}$ von Fig. 2 zeigt den zeitlichen Verlauf der Spannung am Meßkondensator 11 und somit auch die Spannung auf dem Innenleiter 13 des Kabels 12. In jeder Phase I, die dem Wert 1 des Steuersignals A entspricht, wird der Meßkondensator 11 auf die Spannung +U aufgeladen. Die Aufladung erfolgt wegen der unvermeidlichen Zeitkonstante des Ladekreises nicht verzögerungsfrei, doch ist die Dauer der Phase I so groß bemessen, daß die Spannung $U_{CM}$ am Meßkondensator 11 mit Sicherheit den vollen Wert +U erreicht.

In der Phase II, die dem Wert 0 des Steuersignals A entspricht, entlädt sich der Meßkondensator $C_M$ mit der entsprechenden Zeitkonstante in den Speicherkondensator 18. Da die Kapazität $C_0$ des Speicherkondensators 18 sehr groß gegen die Meßkapazität $C_M$ ist, ist die Spannung an diesen beiden Kondensatoren nach dem Ladungsausgleich sehr klein gegen die Spannung +U. Die Dauer der Phase II, die vorzugsweise gleich der Dauer der Phase I ist, ist so bemessen, daß der vollständige Ladungsausgleich mit Sicherheit stattfinden kann.

In der folgenden Phase I wird der Meßkondensator 11 wieder auf die Spannung +U aufgeladen, während die Ladung des Speicherkondensators 18 durch den als Strom-Spannungs-Wandler wirkenden Operationsverstärker 20 langsam abgeführt wird. Der Ladungsausgleich erfolgt durch einen Strom, der über den Widerstand 21 fließt und bewirkt, daß die Spannung am Speicherkondensator 18 im Mittel im wesentlichen auf dem Wert Null gehalten wird. Der über den Widerstand 21 fließende Strom ist gleich dem Mittelwert des Stroms, der vom Meßkondensator 11 entladen wird. Für die Aufrechterhaltung dieses Stroms nimmt die Ausgangsspannung des Operationsverstärkers 20 einen Wert $U_C$ an, der der Meßkapazität $C_M$ exakt proportional ist.

Wenn keine besonderen Maßnahmen getroffen werden, addiert sich die Kabelkapazität $C_K$ des abgeschirmten Kabels 12 zu der Meßkapazität $C_M$, und Kapazitätsänderungen des Kabels wirken sich auf die Messung aus. Zur Ausschaltung des Einflusses der Kabelkapazität wird bei der Kapazitätsmeßschaltung von Fig. 1 eine aktive Schirmung angewendet, indem das Potential der Kabelabschirmung 14 dem Potential auf dem abgeschirmten Innenleiter 13 des Kabels 12 nachgeführt wird. Wenn zusätzlich eine Abschirmelektrode 15 vorhanden und mit der Kabelabschirmung 14 verbunden ist, wird auch das Potential der Abschirmelektrode 15 durch die aktive Schirmung dem Potential der von ihr abgeschirmten Kondensatorelektrode nachgeführt, wodurch der Einfluß von Streukapazitäten und Störfeldern auf die Meßkapazität ausgeschaltet wird. Nach dem Stand der Technik erfolgt eine solche aktive Schirmung dadurch, daß das Potential der abgeschirmten Leitung dauernd abgetastet und über einen Impedanzwandler an die Abschirmung gelegt wird. Im Gegensatz dazu erfolgt bei der Kapazitätsmeßschaltung von Fig. 1 die aktive Schirmung auf besonders einfache und wirksame Weise mit Hilfe des vom Steuersignal B betätigten Umschalters 23, ohne daß eine Rückführung des Potentials der abgeschirmten Leitung notwendig ist.

Das Diagramm B von Fig. 2 zeigt den zeitlichen Verlauf des Steuersignals B, das mit der gleichen Folgefrequenz wie das Steuersignal A periodisch abwechselnd die Werte 0 und 1 annimmt. Das Diagramm $U_K$ von Fig. 5 zeigt den zeitlichen Verlauf der Spannung, die durch den Umschalter 23 an die Kabelabschirmung 14 angelegt wird. Wenn das Steuersignal B den Wert 1 annimmt, wird die Kabelabschirmung 14 an die Spannung +U gelegt, und die Spannung $U_K$ erreicht den Spannungswert +U nach einer durch die Zeitkonstante bedingten Umladezeit $T_K$. Wenn das Steuersignal B den Wert 0 annimmt, wird die Kabelabschirmung 14 an Massepotential gelegt, und die Spannung $U_K$ erreicht den Spannungswert 0 wieder nach der Umladezeit $T_K$.

Aus dem Diagramm von Fig. 2 ist folgendes zu erkennen: Wenn die Steuersignale A und B genau phasengleich sind, haben auch die Spannungen $U_{CM}$ und $U_K$ im wesentlichen den gleichen zeitlichen Verlauf. Damit ist die Bedingung der aktiven Schirmung erfüllt, daß das Potential der Abschirmung ständig dem Potential der abgeschirmten Elektrode folgt. In Fig. 2 sind aber die Steuersignale A und B absichtlich gegeneinander phasenverschoben dargestellt, um zu zeigen, daß es nicht auf die Einhaltung exakter zeitlicher Beziehungen ankommt. Es gibt dann zwar in jeder Phase II am Anfang einen Zeitabschnitt IIa, in welchem sich der Meßkondensator 11 bereits in den Speicherkondensator 18 entlädt, während an der Kabelabschirmung noch die Spannung +U anliegt, so daß sich die Kabelkapazität $C_K$ auflädt und die entsprechende Ladung $Q_K$ in den Speicherkondensator 18 fließt; wenn jedoch anschließend im Abschnitt IIb der gleichen Phase II die Kabelabschirmung 14 an Masse gelegt wird, während der abgeschirmte Leiter 13 noch mit dem Speicherkondensator 18 verbunden ist, fließt im wesentlichen die gleiche Ladung $Q_K$ wieder vom Speicherkondensator 18 in die Kabelkapazität $C_K$ zurück. Diese Ladungsverschiebungen heben sich also im Mittel gegenseitig auf, so daß auf dem Speicherkondensator 18 effektiv nur die zu erfassende Ladung $Q_M$ des Meßkondensators 11 verbleibt. Somit ist die Ladung $Q_M$ allein für den Strom über den Widerstand 21 und damit für die Spannung $U_C$ am Ausgang des Operationsverstärkers 20 maßgeblich.

Die Anforderungen an die zeitliche Lage des Steuersignals B in bezug auf das Steuersignal A sind also unkritisch. Es sind nur die zeitlichen Bedingungen einzuhalten, daß die Abschirmspannung $U_K$ vor dem Beginn jeder Phase II den Spannungswert +U und vor dem Beginn jeder Phase I den Spannungswert 0 erreicht haben muß. Unter Berücksichtigung der Umladezeit $T_K$ bedeutet dies, daß das Steuersignal B spätestens um die Zeitspanne $T_K$ vor dem Beginn jeder Phase II auf den Wert 1 und spätestens um die Zeitspanne $T_K$ vor dem Beginn jeder Phase I auf den Wert 0 gebracht sein muß. Daraus ergeben sich die im Diagramm B' dargestellten zeitlichen Bedingungen: Das Steuersignal B kann in den kreuzschraffierten Bereichen beliebige Werte haben und muß nur in den mit "1" bzw. "0" markierten Bereichen der Dauer $T_K$ den angegebenen Signalwert haben.

Wie bereits erwähnt, soll die Kapazität $C_0$ des Speicherkondensators 18 möglichst groß gegen die Meßkapazität $C_M$ sein. Das Verhältnis $C_0/C_M$ kann in der Praxis den Wert 1000 erreichen. Da dieses Verhältnis aber nicht beliebig groß gemacht werden kann, wird bei der Umladung aus dem Meßkondensator 11 in den Speicherkondensator 18 in der Phase II die Spannung am Speicherkondensator 18 durch die aus dem Meßkondensator 11 stammende Ladung $Q_M$ etwas ansteigen. Dementsprechend fließt im Abschnitt IIb der Phase II auch nicht genau die vollständige Ladung $Q_K$ in die Kabelkapazität $C_K$ zurück, sondern etwas weniger. Die Reduktion der wirksamen Kabelkapazität $C_K$ entspricht deshalb in erster Näherung dem Verhältnis $C_0/C_M$, doch ist der Restfehler vernachlässigbar.

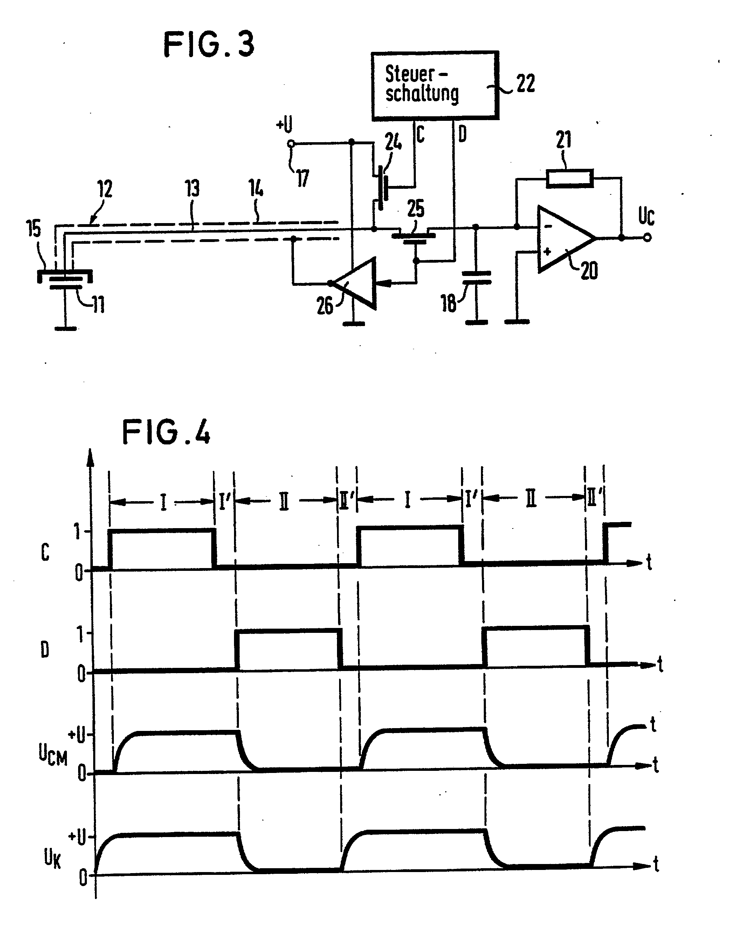

Die Umschalter 16 und 23 sind in Fig. 1 nur symbolisch als mechanische Schalter dargestellt. In Wirklichkeit handelt es sich um schnelle elektronische Schalter, beispielsweise um MOS-Feldeffekttransistoren. Da solche elektronischen Schalter nicht als Umschalter, sondern als einfache Ein-Aus-Schalter wirken, muß jeder Umschalter von Fig. 1 durch zwei derartige elektronische Schalter ersetzt werden. In Fig. 3 ist eine unter Verwendung von elektronischen Schaltern ausgebildete Kapazitätsmeßschaltung dargestellt, und Fig. 4 zeigt die entsprechenden Zeitdiagramme.

Soweit die Bestandteile der Kapazitätsmeßschaltung von Fig. 3 mit denjenigen der Ausführungsform von Fig. 1 übereinstimmen, sind hierfür die gleichen Bezugszeichen verwendet. Die Kapazitätsmeßschaltung von Fig. 3 unterscheidet sich von der Ausführungsform von Fig. 1 in erster Linie dadurch, daß der Umschalter 16 durch zwei MOS-Feldeffekttransistoren 24 und 25 ersetzt ist, die durch Steuersignale C bzw. D angesteuert werden, die von der Steuerschaltung 22 geliefert werden. Der zeitliche Verlauf der Steuersignale C, D ist in dem mit den gleichen Buchstaben bezeichneten Diagramm von Fig. 4 dargestellt. Jedes der beiden Steuersignale C und D nimmt periodisch abwechselnd den Signalwert 0 und den Signalwert 1 an, wobei die beiden Steuersignale im wesentlichen gegenphasig zueinander sind. Jeder MOS-Feldeffekttransistor 24, 25 ist beim Wert 1 des angelegten Steuersignals stromführend und beim Wert 0 des angelegten Steuersignals gesperrt. In der Phase I hat das Steuersignal C den Wert 1 und das Steuersignal D den Wert 0. Demzufolge ist in der Phase I der Meßkondensator 11 mit der Klemme 17 verbunden und vom Speicherkondensator 18 abgetrennt. Dies entspricht der ersten Stellung, die der Umschalter 16 von Fig. 1 in der Phase I von Fig. 2 einnimmt. In der Phase II von Fig. 4 hat das Steuersignal C den Wert 0 und das Steuersignal D den Wert 1, so daß der Meßkondensator 11 von der Klemme 17 abgetrennt und mit dem Speicherkondensator 18 verbunden ist. Dies entspricht der anderen Stellung, die der Umschalter 16 von Fig. 1 in der Phase II von Fig. 2 einnimmt. Somit ergibt die Schaltungsanordnung von Fig. 3 hinsichtlich der Aufladung und Entladung des Meßkondensators 11 in den Phasen I und II die gleiche Wirkung wie die Schaltungsanordnung von Fig. 1.

Gemäß den Zeitdiagrammen von Fig. 4 ist jedoch zwischen jeder Phase I und der folgenden Phase II eine Zwischenphase I' und zwischen jeder Phase II und der folgenden Phase I eine Zwischenphase II' eingefügt, in der die beiden Steuersignale C und D den Wert 0 haben, so daß die beiden MOS-Feldeffekttransistoren 24 und 25 gleichzeitig gesperrt sind. Diese Zwischenphasen sind verhältnismäßig kurz und sollen nur sicherstellen, daß die beiden MOS-Feldeffekttransistoren nicht gleichzeitig Strom führen, denn dann wäre der Speicherkondensator 18 kurzzeitig direkt an die Spannung +U gelegt.

Das Diagramm $U_{CM}$ von Fig. 4 zeigt den zeitlichen Verlauf der Spannung $U_{CM}$ am Meßkondensator 11, der durch die zuvor geschilderte Ansteuerung der MOS-Feldeffekttransistoren 24, 25 mittels der Steuersignale C, D erzielt wird.

Der Umschalter 23 von Fig. 1 könnte in gleicher Weise durch zwei MOS-Feldeffekttransistoren ersetzt werden. Fig. 3 zeigt jedoch eine andere Lösung, die eine weitere Vereinfachung ergibt. Der Umschalter 23 ist hier durch einen als Schwellenwert-Diskriminator wirkenden Inverter 26 ersetzt, dessen Stromversorgungsklemmen an die Spannung +U bzw. an Masse angeschlossen sind. An den Signaleingang des Inverters 26 ist das Steuersignal B angelegt, und der Ausgang des Inverters 26 ist mit der Kabelabschirmung 14 verbunden. Der Inverter 26 ist in der üblichen Weise so ausgebildet, daß seine Ausgangsspannung das höhere Versorgungsspannungspotential annimmt, wenn sein Eingangssignal unter einem vorgegebenen Schwellenwert liegt, also insbesondere den Wert 0 hat, und daß seine Ausgangsspannung das niedrigere Versorgungsspannungspotential annimmt, wenn sein Eingangssignal über dem Schwellenwert liegt, also insbesondere den Wert 1 hat. Praktisch sind die beiden elektronischen Schalter, die zusammen den Umschalter bilden, im Inverter enthalten und so angeordnet, daß sie den Ausgang des Inverters entweder mit der einen oder mit der anderen Versorgungsspannungsklemme verbinden. Bei der Kapazitätsmeßschaltung von Fig. 3 nimmt somit die Ausgangsspannung des Inverters 26 den Wert +U an, wenn das Steuersignal B den Wert 0 hat, und sie nimmt das Massepotential an, wenn das Steuersignal B den Wert 1 hat. Demzufolge hat die Spannung $U_K$ an der Kabelabschirmung 14, die an den Ausgang des Inverters 26 angeschlossen ist, den im Diagramm $U_K$ von Fig. 4 dargestellten zeitlichen Verlauf. Es ist unmittelbar zu erkennen, daß dieser zeitliche Verlauf die zuvor erläuterten Bedingungen für die aktive Schirmung erfüllt, ohne daß enge Zeittoleranzen für die Ansteuerung des Inverters 26 oder für dessen Ansprechgeschwindigkeit einzuhalten sind.

**Patentansprüche**

1. Kapazitätsmeßschaltung mit einer Umschaltanordnung (16), welche die Meßkapazität (11) mit einer vorgegebenen Umschaltfrequenz periodisch abwechselnd zur Aufladung an eine konstante Spannung legt und zur Entladung mit einem Speicherkondensator (18) verbindet, dessen Kapazität groß gegen die Meßkapazität ist und dessen Klemmenspannung durch einen kontrollierten Entladestrom im wesentlichen auf einem konstanten Bezugspotential gehalten wird, wobei die Größe des Entladestroms der Meßkapazität (11) proportional ist und den Meßwert darstellt, gekennzeichnet durch eine weitere Umschaltanordnung (23), welche eine der Meßkapazität zugeordnete Abschirmung mit der Umschaltfrequenz periodisch abwechselnd an Potentiale legt, die im wesentlichen der konstanten Spannung bzw. dem Bezugspotential entsprechen.

2. Kapazitätsmeßschaltung nach Anspruch 1, dadurch gekennzeichnet, daß jede Umschaltanordnung (16, 23) durch zwei elektronische Schalter gebildet ist, die durch gegenphasige Steuersignale geöffnet bzw. gesperrt werden.

3. Kapazitätsmeßschaltung nach Anspruch 2, dadurch gekennzeichnet, daß die weitere Umschaltanordnung (23) durch einen Schwellenwert-Diskriminator gebildet ist, der eines der gegenphasigen Steuersignale empfängt.

**Claims**

1. Capacitance measuring circuit comprising a switchover means (16) which periodically and alternately with a predetermined switchover frequency connects the measured capacitance (11) for charging to a constant voltage and for discharging to a storage capacitor (18) whose capacitance is large compared with the measured capacitance and whose terminal voltage is held substantially at a constant reference potential by a controlled discharge current, the magnitude of the discharge current being proportional to the measured capacitance (11) and representing the measured value, characterized by a further switchover means (23), which with the switchover frequency periodically and alternately connects a shield associated with the measured capacitance to potentials which correspond substantially to the constant voltage and the reference potential respectively.

2. Capacitance measuring circuit according to claim 1, characterized in that each switchover means (16, 23) is formed by two electronic switches which are opened or closed by opposite phase control signals.

3. Capacitance measuring circuit according to claim 2, characterized in that the further switchover means (23) is formed by a threshold value discriminator which receives one of the opposite phase control signals.

**Revendications**

1. Circuit de mesure de capacité, avec un dispositif de commutation (16) qui, de manière alternative et périodique selon une fréquence de commutation donnée, porte la capacité à mesurer à une tension constante pour la charger et, pour la décharger, la relie à un condensateur de stockage (18) dont la capacité est grande par rapport à la capacité à mesurer et dont la tension aux bornes est maintenue sensiblement à un potentiel de référence constant par un courant de décharge contrôlé, l'intensité du courant de décharge étant proportionnelle à la capacité à mesurer (11) et représentant la valeur de la mesure, caractérisé par un second dispositif de commutation (23) qui, de manière alternative et périodique selon la fréquence de commutation, porte un blindage associé à la capacité à mesurer à des potentiels qui correspondent sensiblement à la tension constante et au potentiel de référence, respectivement.

2. Circuit de mesure de capacité selon la revendication 1, caractérisé en ce que chaque dispositif de commutation (16, 23) est constitué de deux commutateurs électroniques qui sont ouverts ou fermés par des signaux de commande en opposition de phase.

3. Circuit de mesure de capacité selon la revendication 2, caractérisé en ce que le second dispositif de commutation (23) est constitué par un discriminateur à seuil qui reçoit un des signaux de commande en opposition de phase.

# FIG.1

Steuerschaltung 22

10

B    A

+U

17

21

12  13  14

15

11

16

23

18

20

$U_C$

# FIG.2

I    II    I    II

A    1
     0                                    t

$U_{CM}$   +U
            0                              t

IIa   IIb

B    1
     0                                    t

$U_K$   +U
         0                                t

$T_K$    $T_K$

B'   1
     0    1    0    1    0                 t

$T_K$    $T_K$    $T_K$    $T_K$

# FIG. 3

Steuer-schaltung 22

+U 17

12 13 14 15 11 24 C D 25 26 18 21 20 Uc

# FIG. 4

I I' II II' I I' II II'

C 1 0 t

D 1 0 t

U_CM +U 0 t

U_K +U 0 t